(19) Europäisches Patentamt
European Patent Office
Office européen des brevets

(11) **EP 2 728 754 A1**

(12) **EUROPEAN PATENT APPLICATION**

(43) Date of publication:
**07.05.2014 Bulletin 2014/19**

(51) Int Cl.:
**H03M 13/27** (2006.01)    *H03M 13/29* (2006.01)

(21) Application number: **12191152.3**

(22) Date of filing: **02.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **BlackBerry Limited Waterloo, ON N2K 0A7 (CA)**

(72) Inventor: **Stafford, Christopher Harston,, Cambridgeshire CB22 7GG (GB)**

(74) Representative: **Brunner, John Michael Owen Carpmaels & Ransford LLP One Southampton Row London WC1B 5HA (GB)**

(54) **Efficient Implementation of a Quadratic Polynomial Permutation (QPP) Interleaver**

(57)    The present disclosure concerns an interleaver according to the 3GPP-LTE standard turbo interleaving function whereby interleaved bit sequence locations are generated from successive bit sequence locations of a bit sequence. The interleaved bit location is derived iteratively using a new first counter value of a first counter based on a current value of the first counter and a first function derived from an interleaver bit sequence function which relates an interleaved bit sequence location to a bit sequence location. A new second counter value of a second counter is then derived based on a current value of the second counter and the first counter. Finally, an interleaved bit sequence location is output based on the value of the second counter.

FIG. 4a

EP 2 728 754 A1

## Description

### Field of the Disclosure

The present disclosure concerns an interleaver and interleaving process which employ counters.

### Background

Interleaving is a process of reordering a sequence of bits, data, symbols or information which is contained in a data sequence, for example by reordering the bits, data, symbols or information in a predefined or random manner. Apparatus which performs interleaving is herein referred to as an "interleaver".

Turbo interleavers are interleavers which are used in the generation of turbo codes, and are used at the output of a first encoder element before the reordered data from the interleaver is further encoded by a second encoder element. Interleaving in the context of turbo encoding means that the separate encodings produced by the two encoder elements are generally uncorrelated. Thus, the outputs of the two encoder elements can then be combined to produce an encoded data sequence which has good error correction performance.

Many interleavers determine the reordering sequence of their input bits, data, symbols or information based on an "interleaver sequence function" which is a mathematical function which takes the position of an input bit, data item, symbol or information block and derives a corresponding output position in the output stream of bits, data, symbols or information.

In existing encoders and decoders, calculation of the interleaver sequence function involves an implementation in hardware or equivalent software. Often, the values that are being determined in the processing of the interleaver sequence function can become large. This means that the processing logic is relatively complex and thus the processing and calculation of interleaved symbol or bit sequences is demanding. This can increase circuit complexity, size and cost, as well as increase power consumption which, for mobile applications, can cause a reduction in battery life. It is thus desirable to reduce and simplify the logic required to implement the interleaver sequence function.

### Drawings

Reference is made below to the accompanying drawings in which:
Fig. 1 is a schematic of a communication system according to the present disclosure;
Fig. 2 is a schematic of signal processing circuitry which could be employed in the communication system of Fig. 1;
Fig. 3 is a schematic of the functional components of an encoder which could be employed in the circuitry of Fig. 2;
Fig. 3a is a schematic showing how bits or symbols according to the present disclosure may be reordered;
Fig. 4 is a schematic of functional components of an interleaver of the present disclosure; and
Fig. 4a is a schematic of logic components within an interleaver according to one embodiment of the invention; and
Fig. 5 is a flow diagram of steps which could be performed by an interleaver of the present disclosure.

### Description

Reference is made below to one or more particular examples which are not intended to be limiting on the scope of the disclosure.

In a first aspect, a method of generating interleaved symbol sequence locations from successive symbol sequence locations of a symbol sequence comprises: deriving a new first counter value of a first counter based on a current value of the first counter and a first function derived from an interleaver sequence function which relates an interleaved symbol sequence location to a symbol sequence location; and deriving a new second counter value of a second counter based on a current value of the second counter and the first counter; and outputting an interleaved symbol sequence location based on the value of the second counter.

The step of deriving the new first counter value may comprise determining IncrCount(i+1) as (IncrCount(i) + $\Pi$''(i)) mod K, wherein i is the symbol sequence location, IncrCount is the first counter value for a given symbol sequence location, $\Pi$''(i) is the second derivative of the interleaver sequence function and K is a constant. The step of deriving the new second counter value may comprise determining IndexCount(i+1) as (IndexCount(i) + IncrCount(i)) mod K, wherein IndexCount is the second counter value for a given symbol sequence location. The first function may be the second derivative of the interleaver sequence function, $\Pi$(i).

The interleaved symbol sequence location which is output for a particular symbol sequence location may be the current value of the second counter which corresponds to the particular symbol sequence location.

The deriving of each new first and second counter value may occur iteratively for successive symbol sequence locations.

In a second aspect, a non-transitory computer readable medium has computer executable instructions stored thereon which, when executed, perform the aforementioned method.

In a third aspect, an interleaver for generating interleaved symbol sequence locations from successive symbol sequence locations of a symbol sequence may comprise: a processing circuit; a first counter; and a second counter, wherein the processing circuit is adapted to derive a new first counter value of the first counter based on a current value of the first counter and a first function derived from an interleaver sequence function which relates an interleaved symbol sequence location to a symbol sequence location; and wherein the processing circuit is adapted to derive a new second counter value of the second counter based on a current value of the second counter and the first counter; and wherein the processing circuit is adapted to output an interleaved symbol sequence location based on the value of the second counter.

The processing circuit may be adapted to derive the new first counter value by determining IncrCount(i+1) as (IncrCount(i) + $\Pi''(i)$) mod K, wherein i is the symbol sequence location, IncrCount is the first counter value for a given symbol sequence location, F''(i) is the first function and K is a constant. The processing circuit may be adapted to derive the new second counter value by determining IndexCount(i+1) as (IndexCount(i) + IncrCount(i)) mod K, wherein Index-Count is the second counter value for a given symbol sequence location. The first function may be the second derivative of the interleaver sequence function, $\Pi(i)$.

The processing circuit may output the current value of the second counter as the interleaved symbol sequence location for a particular symbol sequence location. The processing circuit may be adapted to derive each new first and second counter value iteratively for successive symbol sequence locations.

In a fourth aspect, a device comprises: the aforementioned interleaver; and an encoder for encoding a symbol sequence, wherein the encoder may be configured to perform an interleaving operation by successively passing a symbol sequence location of the symbol sequence to the interleaver and thereby obtain corresponding interleaved symbol sequence location from the interleaver.

In a fifth aspect, a device comprises: the aforementioned interleaver; and a decoder for decoding a symbol sequence, wherein the decoder may be configured to perform an de-interleaving operation by successively passing an interleaved symbol sequence location of an interleaved symbol sequence to the interleaver and thereby obtain corresponding non-interleaved symbol sequence location from the interleaver.

The interleaver can perform interleaving and de-interleaving operations since the interleaver sequence function may be reversible. This is to say a linear symbol sequence input to the interleaver can be reordered such that an interleaved symbol sequence is output, or an interleaved input sequence input to the interleaver can be reordered such that a linear symbol sequence is output.

In a fifth aspect, there may be user equipment for use in a telecommunications network comprising the aforementioned device. The device used in the user equipment may comprise the aforementioned encoder or decoder, or both the aforementioned encoder and decoder.

In the aforementioned interleaver and method, the interleaver sequence function may relate a given symbol sequence location to an interleaved symbol sequence location. This function may be $\Pi(i) = (f_1 \times i + f_2 \times i^2)$ mod K (i), wherein i is the symbol sequence location, and K, $f_1$ and $f_2$ are pre-defined constants. K, $f_1$ and $f_2$ may be defined according to Table 5.1.3-3 of 3GPP TS which is hereby incorporated by reference. The values of Table 5.1.3-3 of 3GPP TS may be stored in memory and obtained therefrom for use in determination of $\Pi(i)$ and/or $\Pi'(i)$, and/or in the deriving of the new first counter, and/or in the deriving of the new second counter value.

Also, in the aforementioned interleaver and method, the new first counter value may be stored in the first counter when it has been derived, and the new second counter value may be stored in the second counter when it has been derived.

Furthermore, in the aforementioned interleaver and method, each symbol may comprise one or more bits, may comprise or consist of a single bit, or may be a single bit. Each symbol sequence (input or output) may be a bit sequence and each symbol location may be a bit location. The reference to a symbol or bit location may be a reference to a symbol or bit index respectively within the corresponding symbol or bit sequence. The symbol sequence may be an input symbol sequence which may be a non-interleaved and/or linear sequence. The interleaved symbol sequence may be an output symbol sequence.

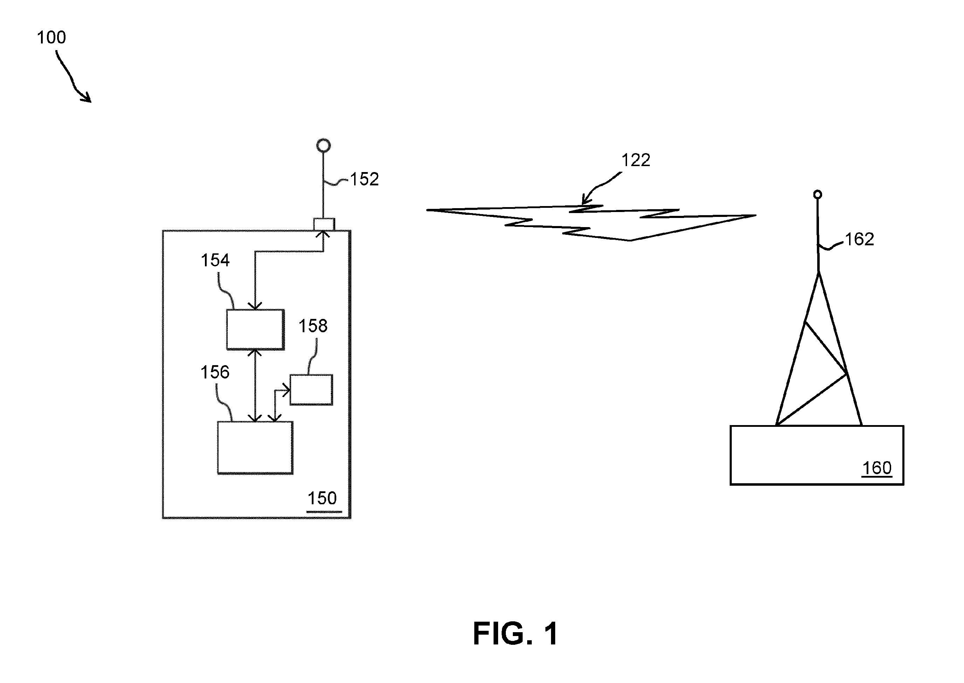

Fig. 1 is an example of a communication system 100 which could employ the present invention. The communication system 100 comprises user equipment (UE) 150 which may be a communication device, such as a mobile device or phone, portable computing device, e.g. laptop or tablet device, or any other device which is adapted to communicate with the system 100. The user equipment (UE) 150 comprises processing circuitry 156 in communication with memory 158. The processing circuitry 156 is also in communication with signal processing circuitry 154 which is connected to antenna 152. The user equipment 150 may also include many other commonplace features which are likely to well-understood by the skilled person. These commonplace features are not shown in Fig. 1 since they are not the direct subject of the present invention, but may include a display screen, keypad or keyboard, touchscreen, power supply, such as a battery, input/output interfaces. Such commonplace features may be directly or indirectly connected to each other, to the processing circuitry 156, memory 158 and/or signal processing circuitry 154, and be in direct or indirect communication with each other, the processing circuitry 156, memory 158 and/or signal processing circuitry 154.

The communication system 100 also comprises a remote station 160, which may be a mobile station (MS), such as a mobile base station or any other device which is capable of communicating within the system 100 and with the user equipment 150. The station 160 may comprise station antenna 162 and signal processing and control circuitry (not shown), which may be directly or indirectly connected to the station antenna 162, and which may be similar or identical to the components of the user equipment as herein described.

Radio frequency (RF) signals 122 are generated by the user equipment 150 and the station 160 and pass between each other via the antenna 152 and station antenna 162, thereby permitting bi-directional communication between the user equipment 150 and the station 160. The RF signals 122 are modulated or demodulated by the user equipment 150 and/or the station 160 according to one or more modulation/demodulation schemes, which permits data, for example digital data, to be transmitted between the station 160 and the user equipment 150. The modulation schemes implemented by the communication system 100 including the user equipment 150 and station 160 may conform to one or more of the schemes defined by Global System for Mobile Communications (GSM), 3rd Generation (3G) mobile communication, 3rd Generation Partnership Project (3GPP) and Long Term Evolution (LTE). The resulting communication network which is formed by the user equipment 150 (or a plurality thereof) and the station 160 (or a plurality thereof) may be a cellular communication network, such as a cellular network conforming to one or more of GSM, 3G, 3GPP and LTE.

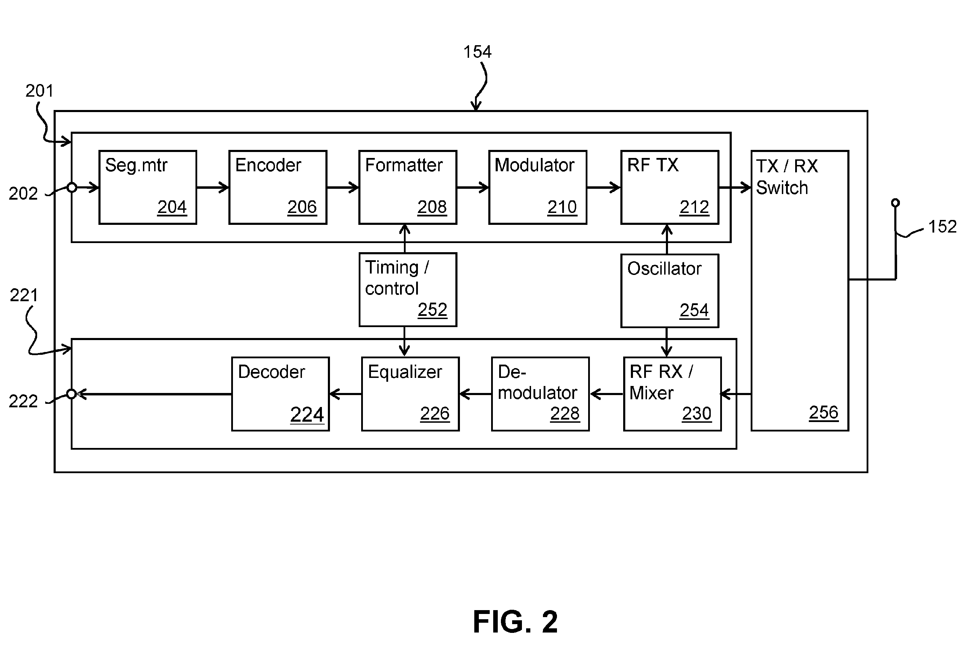

Fig. 2 is a generalised schematic of the signal processing circuitry 154 that might be employed comprising, at a transmitter 201: a transmitter input 202, a segmenter 204, an encoder 206, for example a turbo encoder, a formatter 208, a modulator 210; a radio-frequency (RF) transmitter 212. In addition, at a receiver 221, there is: a receiver output 222; a decoder 224, for example a turbo decoder, an equalizer 226, a demodulator 228; and a mixer 230.

For both the transmitter 201 and receiver 221, there may also be hardware which is shared, such as: the antenna 152 for receiving the RF signals 122 from the communications network, timing and control circuitry 252, and an oscillator 254, along with transmitter-receiver switch 256.

The transmitter 201 receives a digital data stream via transmitter input 202 and this data stream is fed to segmenter 204 where fixed-length data blocks of block size, K, are formed. These fixed-length data blocks are then passed to the encoder 206 which encodes the fixed length data blocks and sends the encoded data blocks successively as an encoded data stream to the formatter 208. The formatter 208 generates, at a prescribed time and with a prescribed amplitude, signal bursts, each comprising a series of waveforms. These bursts are passed to modulator 210 where each burst is modulated to RF frequency by mixing it with a carrier having a known frequency. The transmitter 201 then transmits each modulated burst as the RF signal 122 when the transmitter-receiver switch 256 connects the antenna 152 to the transmitter 201. The oscillator 254, which is connected to the modulator 210 tracks timing and is used by the modulator 210 to generate the carrier waveform. The timing and control circuitry 252 controls the formatting and timing of the bursts as generated by the formatter 208.

For the receiver 221, when the antenna 152 receives the RF signal 122 containing a burst and the radio frequency (RF) receiver / mixer 230 is connected to the antenna 152 via the switch 256, the received burst is amplified in the radio frequency (RF) receiver / mixer 230, and then demodulated in the demodulator 228 so as to remove the RF carrier. The equalizer 226 filters each demodulated burst to produce an enhanced digital signal which is next decoded by decoder 224.

The decoder 224 comprises a concatenation of individual decoder elements (not shown) and an interleaver (see below). By using feedback from each decoder and passing data through the interleaver (see below), each received burst can be decoded, and can then be passed as needed through receiver output 222 to the processing circuitry 156 within the user equipment 150 for use and/or further processing.

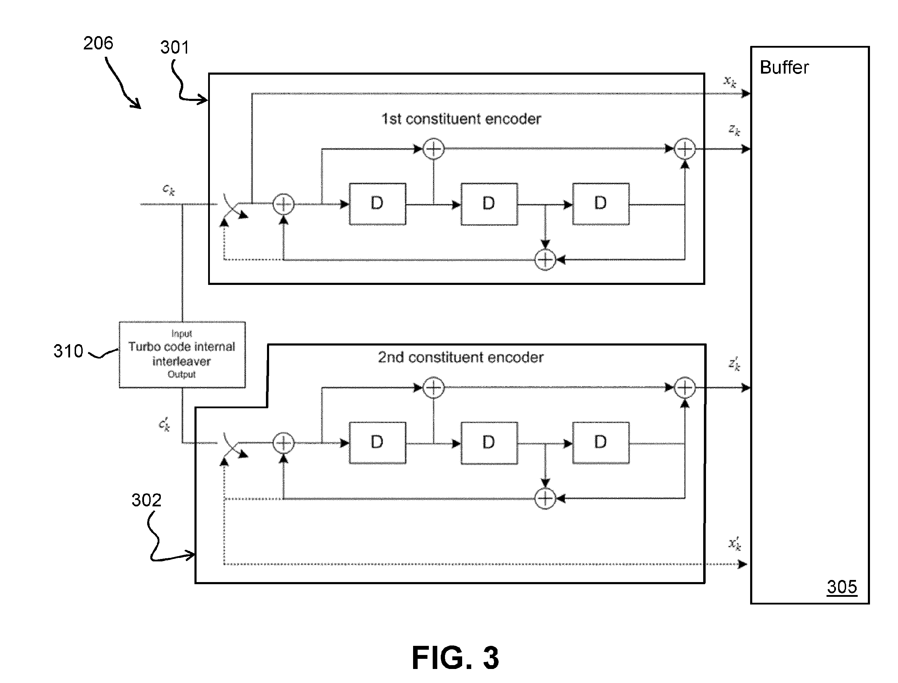

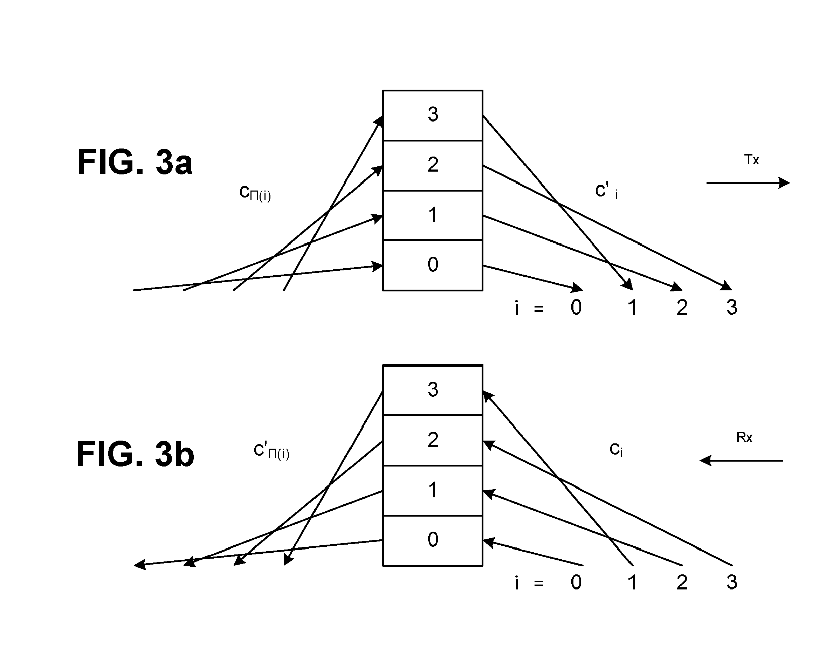

Fig. 3 is a schematic of functional elements of the encoder 206, which may be implemented in hardware, or implemented in software executable on dedicated or shared processing circuitry, or implemented partially for certain elements in software, with other elements implemented hardware. The processing circuitry 156 may perform all or certain elements of the signal processing of the encoder 206 as described below. Alternatively, or in addition, the signal processing circuitry 154 may comprise dedicated processing circuitry and memory for performing all or certain elements of the signal processing as described below.

The example encoder 206 depicted in Fig. 3 includes two constituent encoder elements 301, 302. These encoder elements 301, 302 are both coupled to an interleaver 310. Each encoder element 301, 302 comprises, in the example shown in Fig. 3: modular adders (or binary adders) ("+"); shift register delay elements (or "shift registers") ("D"); and a switch. As shown in the example of Fig. 3, data, bits or information is/are output from each encoder element 301, 302 to a buffer 305. Data, bits or information, $c_k$, is/are also input to encoder element 301 and to the interleaver 310, e.g. from input 202 or segmenter 204. Reordered data, bits or information, $c'_k$, are then output from the interleaver 310 to encoder element 302. The function of the encoder elements 301, 302 is described in one example according to the 3rd Generation Partnership Project (3GPP) (see 3GPP Technical Specification 36.212 v 11.0.0 as herein incorporated by reference, with particular reference to section 5.1.3.2.).

The interleaver employed in 3GPP TS 36.212 determines the order of output bits with respect to the input data, bits or information according to a pre-defined function. In particular, the relationship between the input and output bits can be defined by the following expression:

$$c'_i = c_{\Pi(i)}, \text{ i=0, 1,..., (K-1)} \qquad \text{(Eq. 1),}$$

where the data, bits or information input to the interleaver, for example the interleaver 310 as depicted in Fig. 3, are denoted by $c_0, c_1, ... c_{k-1}$, and where K is the number of input bits, commonly referred to as the block size. The data, bits or information output from the interleaver, for example the interleaver 310 as depicted in Fig. 3, are denoted by $c'_0$, $c'_1, ..., c'_{k-1}$.

The order of bits in Eq. 1 is reversible in the sense that there is simply a transformation from a given input bit location to an output bit location, and this transformation can be defined by an interleaver sequence function (see below) for reordering bits or symbols in a bit or symbol sequence. In the specific examples described below, reference is made to the reordering of individual bits in a bit sequence. However, it will be appreciated that the reordering of bits is a subset of the reordering of symbols, whereby one or more bits constitute a symbol within a symbol sequence. Hence, the principles disclosed below concerning bit reordering are equal applicable to the more general scenario whereby symbols are reordered. According to the invention as defined by the claims, a symbol may be a bit, e.g. a single bit, or it may be a group of one or more bits. An input symbol sequence may be reordered to generate a reordered output symbol sequence whereby the groups of one or more bits making up each symbol have been reordered. The location of a given symbol or bit in the input sequence may designated by or equate to an index, e.g. $\Pi(i)$, and the location of a given symbol or bit in the output sequence may be designated by or equate to an index, e.g. i. $\Pi(i)$ is an example of a value determined by an interleaver sequence function (see below).

In an implementation of the interleaver (see Fig. 3a) for encoding, the input and output bits may simply be stored in a buffer 370 and bits are input in a linear fashion into the buffer and read out in an order according to the interleaver sequence function. In an implementation of the interleaver (see Fig. 3b) for decoding, the bits are input into the buffer in an order according to the interleaver sequence function and output in a linear fashion.

The relationship between the indices of the input and output bits or symbols can be determined according to 3GPP TS 36.212 from the following expression which can be called the interleaver sequence function:

$$\Pi(i) = \left(f_1 \cdot i + f_2 \cdot i^2\right) \bmod K \qquad \text{(Eq. 2),}$$

where the parameters $f_1$ and $f_2$ are defined according to the block size K and are summarized in Table 5.1.3-3 of 3GPP TS 36.212, which is herein incorporated by reference.

In existing encoders and decoders, calculation of $(f_1 \cdot i + f_2 \cdot i^2)$ is implemented in hardware, or in equivalent software, employing three multiplier elements and one adder element. Due to the values of $f_1$ and $f_2$ and block size K defined according to in Table 5.1.3-3 of 3GPP TS 36.212, the result of $(f_1 \cdot i + f_2 \cdot i^2)$ can be very large, e.g. greater than 30 bits, perhaps, 31, 32, 33, 34 or 35 bits in length. For example from Table 5.1.3-3 of 3GPP TS 36.212, for K=5248, $f_1$= 113 & $f_2$ = 902 and a max value of i = 5247:

$$\Pi(i) = (113 \times 5427 + 902 \times 54272) \bmod 5428 = 26566614009 \bmod 5428.$$

where 26566614009 is a larger number which requires 35 bit number to represent it. The application of *mod K* to the large value which is obtained from $(f_1 \cdot i + f_2 \cdot i^2)$ thus involves considerable divider logic which can be complex to implement and inefficient in processing.

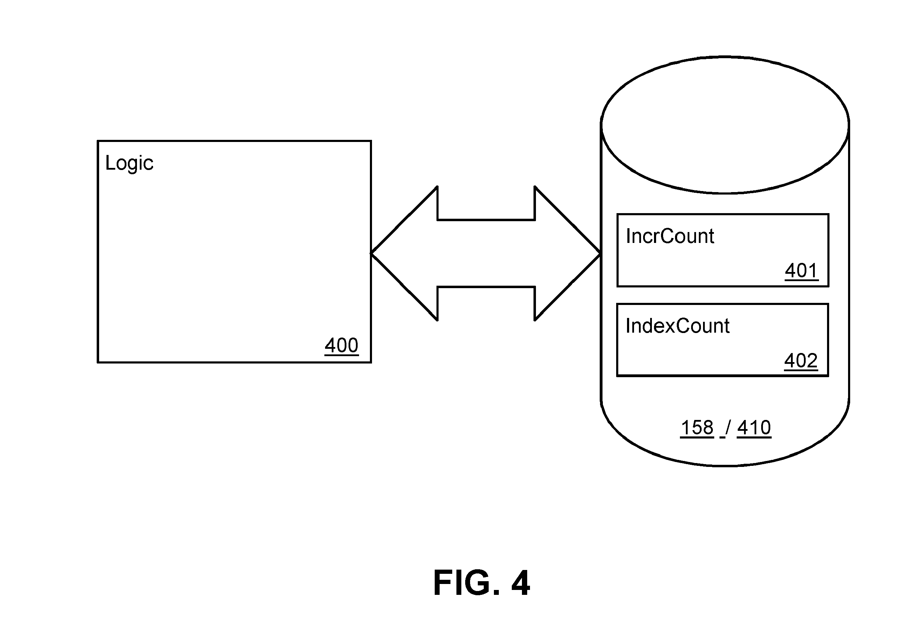

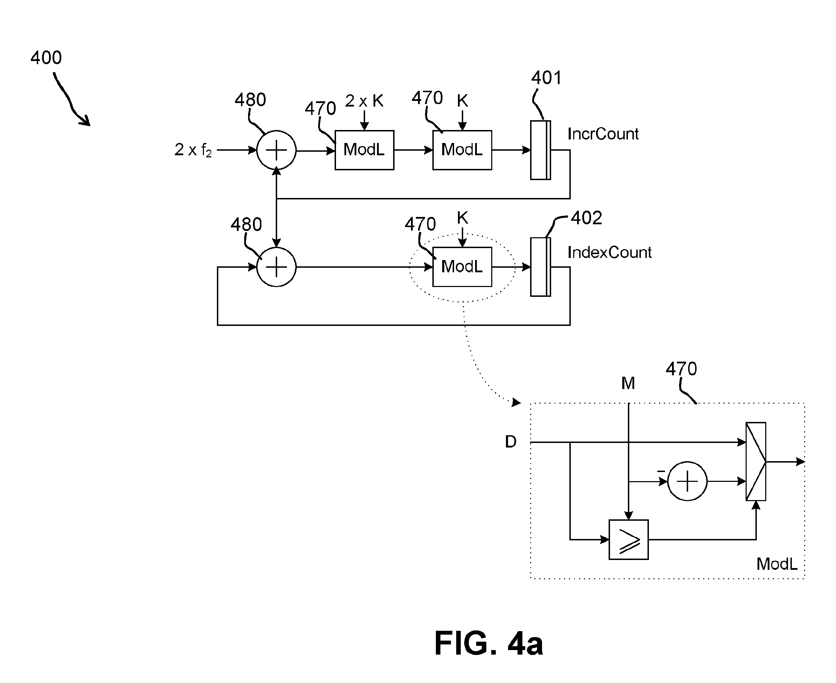

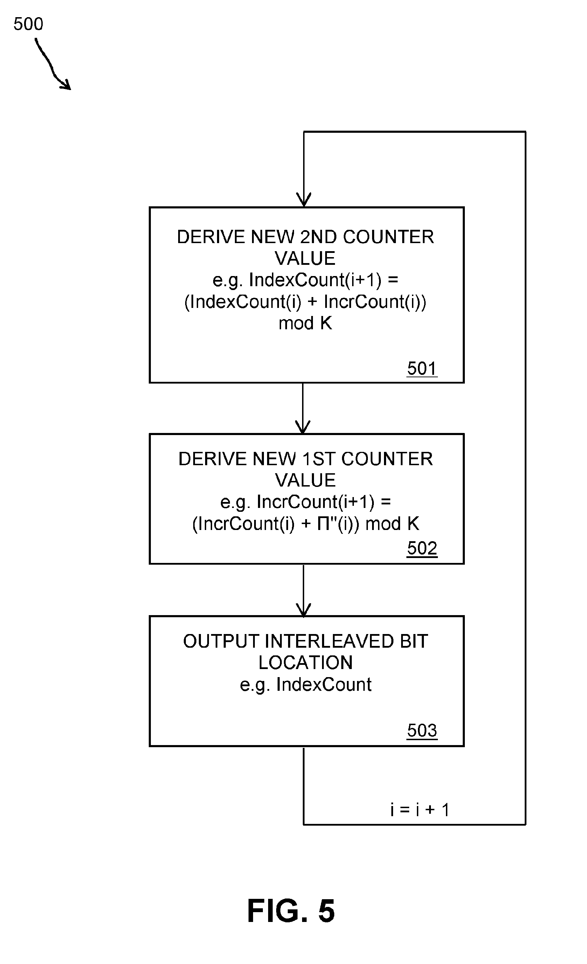

The functional elements or logic in the example interleaver 310 are shown in Fig. 4. These functional elements or logic may be implemented in dedicated hardware, or implemented in software executable on dedicated or shared processing circuitry, or implemented partially for certain elements in software, with other elements implemented hardware. These functional elements or logic implement the general process 500 described below with reference to Fig. 5.

As shown in Fig. 4, the example interleaver 310 comprises a processing block 400 in communication with a first counter 401 and a second counter 402. The first counter 401 and/or second counter 402 may be implemented in memory, which may be the memory 158 of the user equipment 150, or other separate or dedicated memory 410. The functional elements or logic in the example interleaver 310 may be implemented in a computer readable medium, for example a non-transitory computer readable medium, having computer executable instructions stored thereon, which, when executed, perform the general process 500 described below with reference to Fig. 5. Alternatively, the functional elements or logic in the example interleaver 310 may be implemented in hardware components as shown in Fig. 4a which is now discussed below.

As shown in the example of Fig. 4a, there are interconnected logic blocks, specifically modulus blocks 470, and adder blocks 480. A first adder block outputs to two successive modulus blocks (the first performing a modulus with respect to 2K, and the second performing a modulus with respect to K). The output of the second modulus block is input to the first counter 401 which maybe a buffer in memory. The first adder block outputs to a third modulus block which outputs to the second counter 402 which maybe a buffer in memory. The first adder block receives the output of the first counter 401 and adds this with the increment, such as the second derivative of the interleaver bit sequence function, e.g. $2f_2$. The second adder block receives the value of the second counter 402 and adds this to the value of the first counter 401.

With reference to Fig. 5, a process 500 is depicted in which interleaved or re-ordered bit locations are generated from successive bit locations of an input bit sequence. First, according to step 501, a new second counter value of the second counter 402 is derived based on a current value of the second counter and the first counter. Second, according to step 502, a new first counter value of the first counter 401 is derived based on a current value of the first counter and a first function which is based on an interleaver bit sequence function, e.g. $\Pi(i)$, relating an interleaved bit sequence location to an input bit sequence location, e.g. i. For example the interleaver bit sequence function may be $\Pi(i) = (f_1 \times i + f_2 \times i^2)$ mod K, as, for example, defined in 3GPP TS 36.212 section 5.1.3.2.3. Here, i is the input bit sequence location, and K, f1 and f2 are pre-defined constants. According to step 503, an interleaved bit location is derived based on the value of the second counter and can be output to memory, for example to a lookup table storing the correspondence between input bit sequence location and output bit location. Alternatively, the actual bit located at the input bit location is placed into an output register at the derived interleaved bit location. Finally, the bit sequence location for the input bit stream is then incremented, e.g. by 1, and the process 500 repeats for the next bit position in the input bit sequence, so as to derive its corresponding interleaved bit position. When all the bits in the input bit sequence (up to a block size, K) have been reordered, or their interleaved positions determined, the process 500 terminates. At this point, the entire interleaved bit sequence from the output register is output, or, if not already generated, is generated based on the interleaved locations located in the lookup table.

Applying the aforementioned process, the functional elements or logic in the interleaver 310 which are thus necessary to relate the indices of the input bits, $c_k$, to the corresponding indices of the output bits, $c'_k$, can be significantly reduced vis-à-vis existing interleavers. In general, the deriving of each new first and second counter value may occur iteratively for successive bit sequence locations.

In one embodiment, deriving the new first counter value may comprise determining

$$\text{IncrCount}(i+1) \text{ as } (\text{IncrCount}(i) + \Pi''(i)) \text{ mod } K,$$

where i is the bit sequence location, IncrCount is the first counter value of the first counter 401 for a given bit sequence location, $\Pi''(i)$ is the the first function and K is a constant. The first function may be the second derivative of the interleaver bit sequence function, $\Pi(i)$.

In a further embodiment, the step of deriving the new second counter value can comprise determining:

$$\text{IndexCount}(i+1) \text{ as } (\text{IndexCount}(i) + \text{IncrCount}(i)) \text{ mod } K,$$

where IndexCount is the second counter value of the second counter 402 for a given bit sequence location.

The interleaved bit sequence location which may be output for a given bit sequence location may be the current value of the second counter 402 corresponding to the particular bit sequence location, i.

As a general rule in this specific example, at each successive iteration, the second counter 402, e.g. IndexCount, is incremented by the value of first differential of the interleaver bit sequence function, e.g. $(f_1 + 2 \times f_2 \times i)$, which is generated by the existing value of the first counter 401, e.g. IncrCount. In addition, at each successive iteration, the first counter 401, e.g. IncrCount, is incremented by value of the second differential of the interleaver bit sequence function, e.g. $2 \times f_2$, (constant for a given value of K).

The initial values for both the first counter 401 and the second counter 402 can be taken from the interleaver bit sequence function, e.g.:

$$\Pi(i) = (f_1 \times i + f_2 \times i^2) \bmod K.$$

The initial value of the second counter 402, e.g. IndexCount, is the first sequence value of the interleaver bit sequence function where i=0, e.g.:

$$\Pi(0) = 0.$$

The initial value of the first counter 401, e.g. IncrCount, is the first increment value which is applied to IndexCount, i.e. it is the first increment which is applied to the second counter 402, e.g. IndexCount, i.e. setting i=1, for example.:

$$\Pi(1) = f_1 + f_2.$$

A specific example applying the process 500 of Fig. 5 for example values of K=160, $f_i$=21 and $f_2$=120 (see 16th row of Table 5.1.3-3 of 3GPP TS 36.212) and where the second counter 402 is designated as IndexCount and the first counter 401 is designated as IncrCount, is as follows:

i. The initial value of IndexCount is set to zero.

ii. The initial value of the IncrCount is obtained by setting i = 1 in the interleaver bit sequence function, e.g. IncrCount = $\Pi(1) = f_1 + f_2$ = 21 + 120 = 141.

iii. IndexCount, is incremented by the current value of IncrCount, and mod K is applied to the exiting value of the IndexCount and IncrCount in generating the new IndexCount value.

iv. IncrCount is incremented by the second differential of the interleaver bit sequence function, e.g. $2 \times f_2$ = 2 x 120 = 240.

v. mod K is also applied to IncrCount, so IncrCount increment = 240 mod 160 = 80 (which is now the increment applied on each iteration).

Hence, the IncrCount sequence in this specific example becomes :

i. IncrCount(0) = 141 (initial condition)

ii. IncrCount(1) = (141 + 80) mod 160 = 61

iii. IncrCount(2) = (61 + 80) mod 160 = 141 etc.

As a general rule, then:

$$\text{IndexCount}(i+1) = (\text{IndexCount}(i) + \text{IncrCount}(i)) \bmod K.$$

In existing interleaver arrangements, if the value of each counter is not limited, then the counter values become large which means that big counters are required and mod K becomes difficult to implement since it requires divider logic.
However, since:

$$\text{IndexCount}(i+1) = ((\text{IndexCount}(i) \bmod K) + (\text{IncrCount}(i) \bmod K)) \bmod K$$

then:

$$\text{IncrCount}(i+1) = (\text{IncrCount}(i) + 2xf_2) \bmod K$$

As a result, it can be seen that IndexCount sequences in the correct way, but the counter size is kept low, and this makes mod K easy to generate in logic or functional elements.

Coming back to the example for K = 160, $f_1$ = 21, $f_2$ = 120, then the following table shows the progression of values for the direct calculation, and through use of IncrCount and IndexCount:

| i | Direct calculation of: $(f_1 \times i + f_2 \times i^2)$ | Applying mod K: $(f_1 \times i + f_2 \times i_2)$ mod K | IncrCount | IndexCount |
|---|---|---|---|---|
| 0 | 0 | 0 | 141 | 0 |
| 1 | 141 | 141 | 61 | 141 |
| 2 | 522 | 42 | 141 | 42 |
| 3 | 1143 | 23 | 61 | 23 |
| 4 | 2004 | 84 | 141 | 84 |
| 5 | 3105 | 65 | 61 | 65 |
| etc. | ... | ... | ... | ... |

It will be appreciated that the invention has been described above by way of examples, and that modifications departing from the examples may be applicable within the scope of the invention, which is defined by the appendant claims.

**Claims**

1. A method of generating interleaved symbol sequence locations from successive symbol sequence locations of a symbol sequence comprising:

   deriving a new first counter value of a first counter based on a current value of the first counter and a first function derived from an interleaver sequence function which relates an interleaved symbol sequence location to a symbol sequence location; and
   deriving a new second counter value of a second counter based on a current value of the second counter and the first counter; and
   outputting an interleaved symbol sequence location based on the value of the second counter.

2. The method of claim 1, wherein the step of deriving the new first counter value comprises determining IncrCount(i+1) as (IncrCount(i) + $\Pi''(i)$) mod K, wherein i is the symbol sequence location, IncrCount is the first counter value for a given symbol sequence location, $\Pi''(i)$ is the second derivative of the interleaver sequence function and K is a constant.

3. The method of claim [50], wherein the step of deriving the new second counter value comprises determining Index-Count(i+1) as (IndexCount(i) + IncrCount(i)) mod K, wherein IndexCount is the second counter value for a given symbol sequence location.

4. The method of any one of the preceding claims, wherein the first function is the second derivative of the interleaver sequence function, $\Pi(i)$.

5. The method of any one of the preceding claims, wherein the interleaver sequence function which relates a given symbol sequence location to an interleaved symbol sequence location is $\Pi(i) = (f_1 \times i + f_2 \times i^2)$ mod K (i), wherein i is the symbol sequence location, and K, $f_1$ and $f_2$ are pre-defined constants.

6. The method of any one of the preceding claims, wherein the interleaved symbol sequence location which is output for a particular symbol sequence location is the current value of the second counter which corresponds to the particular symbol sequence location.

7. The method of any one of the preceding claims, wherein the deriving of each new first and second counter value occurs iteratively for successive symbol sequence locations.

8. A non-transitory computer readable medium having computer executable instructions stored thereon, when executed, perform the method of any one of the preceding claims.

9. An interleaver for generating interleaved symbol sequence locations from successive symbol sequence locations of a symbol sequence comprising:

a processing circuit;
a first counter; and
a second counter,
wherein the processing circuit is adapted to derive a new first counter value of the first counter based on a current value of the first counter and a first function derived from an interleaver sequence function which relates an interleaved symbol sequence location to a symbol sequence location; and
wherein the processing circuit is adapted to derive a new second counter value of the second counter based on a current value of the second counter and the first counter; and
wherein the processing circuit is adapted to output an interleaved symbol sequence location based on the value of the second counter.

10. The interleaver of claim 9, wherein the new first counter value is stored in the first counter when it has been derived, and the new second counter value is stored in the second counter when it has been derived.

11. The interleaver of claim 9 or claim 10, wherein the processing circuit is adapted to derive the new first counter value by determining $IncrCount(i+1)$ as $(IncrCount(i) + \Pi''(i))$ mod $K$, wherein $i$ is the symbol sequence location, $IncrCount$ is the first counter value for a given symbol sequence location, $F''(i)$ is the first function and $K$ is a constant.

12. The interleaver of claim 11, wherein the processing circuit is adapted to derive the new second counter value by determining $IndexCount(i+1)$ as $(IndexCount(i) + IncrCount(i))$ mod $K$, wherein $IndexCount$ is the second counter value for a given symbol sequence location.

13. The interleaver of any one of claims 9 to 12, wherein the first function is the second derivative of the interleaver sequence function, $\Pi(i)$.

14. The interleaver of any one of claims 9 to 13, wherein the interleaver sequence function which relates a given symbol sequence location to an interleaved symbol sequence location is $\Pi(i) = (f_1 \times i + f_2 \times i^2)$ mod $K$ $(i)$, wherein $i$ is the symbol sequence location, and $K$, $f_1$ and $f_2$ are pre-defined constants.

15. The interleaver of any one of claims 9 to 14, wherein the processing circuit outputs the current value of the second counter as the interleaved symbol sequence location for a particular symbol sequence location.

16. The interleaver of any one of claims 9 to 15, wherein the processing circuit is adapted to derive each new first and second counter value iteratively for successive symbol sequence locations.

17. A device comprising:

the interleaver of any one of claims 9 to 16; and
an encoder for encoding a symbol sequence,
wherein the encoder is configured to perform an interleaving operation by successively passing a symbol sequence location of the symbol sequence to the interleaver and thereby obtain corresponding interleaved symbol sequence location from the interleaver.

18. User equipment for use in a telecommunications network comprising the device of claim 17

FIG. 1

**FIG. 2**

EP 2 728 754 A1

**FIG. 3**

EP 2 728 754 A1

# FIG. 3a

$c_{\Pi(i)}$

3
2
1
0

$c'_i$

Tx

i = 0 1 2 3

# FIG. 3b

$c'_{\Pi(i)}$

3
2
1
0

$c_i$

Rx

i = 0 1 2 3

FIG. 4

FIG. 4a

500

```
┌─────────────────────────────────┐
│   DERIVE NEW 2ND COUNTER        │
│            VALUE                │
│   e.g. IndexCount(i+1) =        │
│   (IndexCount(i) + IncrCount(i))│
│            mod K                │
│                                 │
│                          501    │
└─────────────────────────────────┘
```

$$\text{IndexCount}(i+1) = (\text{IndexCount}(i) + \text{IncrCount}(i)) \bmod K$$

501

```
┌─────────────────────────────────┐
│   DERIVE NEW 1ST COUNTER        │
│            VALUE                │
│   e.g. IncrCount(i+1) =         │
│   (IncrCount(i) + Π"(i)) mod K  │
│                          502    │
└─────────────────────────────────┘
```

$$\text{IncrCount}(i+1) = (\text{IncrCount}(i) + \Pi''(i)) \bmod K$$

502

```
┌─────────────────────────────────┐
│   OUTPUT INTERLEAVED BIT        │
│           LOCATION              │
│      e.g. IndexCount            │
│                                 │
│                          503    │
└─────────────────────────────────┘
```

503

$i = i + 1$

# FIG. 5

Europäisches
Patentamt

European
Patent Office

Office européen
des brevets

# EUROPEAN SEARCH REPORT

**Application Number**

EP 12 19 1152

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ASGHAR R ET AL: "Dual standard re-configurable hardware interleaver for turbo decoding", PROC., 3RD IEEE INTERNATIONAL SYMPOSIUM ON WIRELESS PERVASIVE COMPUTING, ISWPC 2008, 7 May 2008 (2008-05-07), pages 768-772, XP031281345, ISBN: 978-1-4244-1652-3 * page 768; figure 1 * * page 769; figure 2 * ----- | 1-18 | INV. H03M13/27 ADD. H03M13/29 |
| X | WO 2011/041592 A2 (QUALCOMM INC [US]; PAN HANFANG [US]; HOWARD MICHAEL A [US]; WEI YONGBI) 7 April 2011 (2011-04-07) * abstract * * paragraph [0024] - paragraph [0026] * * paragraph [0039] - paragraph [0045]; figure 3 * ----- | 1-18 | |
| X | YANG SUN ET AL: "Configurable and scalable high throughput turbo decoder architecture for multiple 4G wireless standards", PROC., IEEE INTERNATIONAL CONFERENCE ON APPLICATION-SPECIFIC SYSTEMS, ARCHITECTURES AND PROCESSORS, ASAP 2008, 2 July 2008 (2008-07-02), pages 209-214, XP031292402, ISBN: 978-1-4244-1897-8 * abstract * * page 212; figure 6 * ----- -/-- | 1-18 | TECHNICAL FIELDS SEARCHED (IPC) H03M |

The present search report has been drawn up for all claims

| Place of search | Date of completion of the search | Examiner |
|---|---|---|
| Munich | 5 February 2013 | Offer, Elke |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**EUROPEAN SEARCH REPORT**

Application Number

EP 12 19 1152

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ERICSSON: "Quadratic Permutation Polynomial Interleavers for LTE Turbo Coding", 3GPP DRAFT; R1-063137, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. Riga, Latvia; 20061101, 1 November 2006 (2006-11-01), XP050103593, [retrieved on 2006-11-01] * page 1 - page 2 * ----- | 1-18 | |

TECHNICAL FIELDS
SEARCHED (IPC)

The present search report has been drawn up for all claims

| Place of search | Date of completion of the search | Examiner |
|---|---|---|
| Munich | 5 February 2013 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 728 754 A1**

## ANNEX TO THE EUROPEAN SEARCH REPORT
## ON EUROPEAN PATENT APPLICATION NO.

EP 12 19 1152

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2013

| Patent document cited in search report | Publication date | Patent family member(s) | Publication date |
|---|---|---|---|
| WO 2011041592 A2 | 07-04-2011 | US 2011075615 A1<br>WO 2011041592 A2 | 31-03-2011<br>07-04-2011 |

EPO FORM P0459

For more details about this annex : see Official Journal of the European Patent Office, No. 12/82